# EUROPÄISCHE PATENTSCHRIFT

(11) **EP 1 093 225 B1**
(45) Veröffentlichungstag und Bekanntmachung des Hinweises auf die Patenterteilung: **08.06.2005**
(21) Anmeldenummer: 00122541.6
(22) Anmeldetag: 16.10.2000
(51) Int. Cl.: H03K 17/955

(54) **Näherungsschalter**
Proximity switch
Commutateur de proximité

(30) Priorität: 15.10.1999 DE 19949998
(43) Veröffentlichungstag der Anmeldung: 18.04.2001
(73) Patentinhaber: i f m electronic gmbh, D-45127 Essen (DE)
(72) Erfinder: Palata, Jaromir, 88046 Friedrichshafen (DE); Schulz, Jörg, 6890 Lustenau (AT)
(74) Vertreter: Gesthuysen, von Rohr & Eggert

(56) Entgegenhaltungen:
- EP-A- 0 438 634
- EP-A- 0 908 736
- EP-A- 0 945 984
- CH-A- 584 981
- DE-A- 4 004 530
- DE-A- 19 701 899
- US-A- 4 972 154

## Beschreibung

Die Erfindung betrifft einen Näherungsschalter, insbesondere einen kapazitiven Näherungsschalter.

Näherungsschalter, insbesondere induktive, kapazitive und optoelektronische Näherungsschalter, werden in einer Vielzahl von ganz unterschiedlichen Anwendungsgebieten eingesetzt. Dabei kann es sich sowohl um berührungslos arbeitende Näherungsschalter handeln, d. h. um solche Näherungsschalter, bei denen sich ein Betätigungsobjekt lediglich der sensitiven Fläche des Näherungsschalters nähert, als auch um berührend arbeitende Näherungsschalter, d. h. um solche Näherungsschalter, bei denen ein Betätigungsobjekt die sensitive Fläche des Näherungsschalters berührt.

Insbesondere sind Näherungsschalter bekannt, die zwei sensitive Flächen, auch Empfangselektroden genannt, und eine aktive Fläche, auch Sendeelektrode genannt, aufweisen. Bei diesen Näherungsschaltern führt das Sich-Nähern eines Betätigungsobjektes dazu, daß sich die Impedanzen zwischen der Sendeelektrode und der ersten Empfangselektrode einerseits sowie zwischen der Sendeelektrode und der zweiten Empfangselektrode andererseits ändern. Folglich fließt von der Sendeelektrode ein erster Strom zur ersten Empfangselektrode und ein zweiter Strom zur zweiten Empfangselektrode. Es kann jedoch auch so sein, daß sich lediglich die Spannungen an den Empfangselektroden ändern, ohne daß Ströme fließen.

Eingangs ist gesagt worden, daß die Erfindung insbesondere einen kapazitiven Näherungsschalter betrifft. Dann handelt es sich bei den sich ändernden Impedanzen zwischen der Sendeelektrode und der ersten Empfangselektrode einerseits sowie zwischen der Sendeelektrode und der zweiten Empfangselektrode andererseits um sich ändernde Kapazitäten. Nachfolgend wird die Erfindung in bezug auf kapazitive Näherungsschalter beschrieben. Das der Erfindung zugrundeliegende Problem, die daraus fließende Aufgabe und die Lösung dieser Aufgabe sind jedoch nicht auf kapazitive Näherungsschalter beschränkt. Insbesondere gilt alles das, was nachfolgend erläutert wird, auch für induktive und auch für optoelektronische Näherungsschalter.

Bei den Näherungsschaltern, von denen die Erfindung ausgeht, sind, wie bereits ausgeführt, eine Sendeelektrode und zwei Empfangselektroden vorgesehen; anders ausgedrückt gehören zu den bekannten Näherungsschaltern, von denen die Erfindung ausgeht, ein Signalsender und zwei Signalempfänger. Jeder der beiden Empfangselektroden ist also ein Signalempfänger zugeordnet, anders ausgedrückt ein Verarbeitungskanal nachgeschaltet. Damit ist der systembedingte Nachteil verbunden, daß die Verarbeitung des Empfangssignals der ersten Empfangselektrode über den ersten Verarbeitungskanal bzw. in dem ersten Signalempfänger und die Verarbeitung des Empfangssignals der zweiten Empfangselektrode über den zweiten Verarbeitungskanal bzw. in dem zweiten Signalempfänger voneinander abweichen können.

Aus der CH 584 981 A ist ein kapazitiver Näherungsschalter mit zwei Signalsendern und zwei Signalempfängern bekannt. Zu den beiden Signalempfängern gehört jeweils ein Verarbeitungskanal, die ausgangsseitig an einen Komparator angeschlossen sind. Die Signalsender sind über Signalübertragungswege mit den Signalempfängern verbunden. Wenigstens einer der beiden Signalübertragungswege ist beeinflußbar.

Aus der DE 40 04 530 A ist ein Abstandssensor bekannt, der zur Verwendung in einem Näherungsschalter geeignet ist. Zu diesem Abstandssensor gehören zwei Signalsender und ein Signalempfänger. Die beiden Signalsender sind einerseits - jeweils mit ihrem ersten Signalausgang - miteinander und mit einem ersten Signaleingang des Signalempfängers verbunden und andererseits - jeweils mit ihrem zweiten, optischen Signalausgang - über jeweils einen optischen Signalübertragungsweg mit dem zweiten Signaleingang des Signalempfängers verbunden. Wenigstens einer der beiden optischen Signalübertragungswege ist beeinflußbar.

Der Erfindung liegt nun die Aufgabe zugrunde, einen Näherungsschalter der weiter oben beschriebenen Art, insbesondere einen kapazitiven Näherungsschalter anzugeben, der frei ist von dem weiter oben erläuterten systembedingten Nachteil.

Gegenstand der Erfindung ist nun zunächst und im wesentlichen ein Näherungsschalter, insbesondere ein kapazitiver Näherungsschalter, mit zwei Signalsendern und mit einem Signalempfänger, wobei die beiden Signalsender aus einem beiden Signalsendern gemeinsamen Signalgenerator gespeist werden, an beiden Signalausgängen jedes Signalsenders jeweils ein Ausgangssignal der gleichen Frequenz ansteht und die Ausgangssignale an den jeweils ersten Signalausgängen im unbetätigten Zustand die gleiche Amplitude bei einer Phasenverschiebung von 180° haben und wobei die beiden Signalsender einerseits - jeweils mit ihrem ersten Signalausgang - miteinander und mit einem ersten Signaleingang des Signalempfängers, verbunden sind und andererseits - jeweils mit ihrem zweiten Signalausgang - über jeweils einen Signalübertragungsweg mit dem zweiten Signaleingang des Signalempfängers verbunden oder verbindbar sind und wobei wenigstens einer der beiden Signalübertragungswege - durch ein Betätigungsobjekt - beeinflußbar ist. Von den Signalsendern werden also "gleiche Ausgangssignale" abgegeben, also Wechselspannungssignale mit gleicher Frequenz und gleicher Amplitude.

Wenn zuvor davon ausgegangen worden ist, daß jeder der beiden Signalsender einen ersten Signalausgang und einen zweiten Signalausgang aufweist, dann soll damit nur zum Ausdruck gebracht sein, daß eine Signalspannung nur zwischen zwei Signalausgängen anstehen kann bzw. ein Signalstrom nur über zwei Signalausgänge fließen kann; mit der Aussage, daß jeder der beiden Signalsender zwei Signalausgänge aufweist, soll also nicht zum Ausdruck gebracht sein, daß zwei - ggf. unterschiedliche - Signalspannungen anstehen bzw. Signalströme fließen. Mit der Aussage, daß der Signalempfänger zwei Signaleingänge aufweist, soll dementsprechend zum Ausdruck gebracht sein, daß eine Signalspannung nur zwischen zwei Signaleingängen anstehen kann bzw. ein Signalstrom nur zwischen zwei Signaleingängen fließen kann.

Zuvor ist ausgeführt worden, daß wenigstens einer der beiden Signalübertragungswege - zwischen den beiden Signalsendern und dem Signalempfänger - beeinflußbar ist, nämlich durch ein Betätigungsobjekt. Zu dieser Aussage gehört implizit auch, daß auch beide Signalübertragungswege - durch ein Betätigungsobjekt - beeinflußbar sein können.

Sowohl für die Näherungsschalter, von denen die Erfindung ausgeht, als auch für den erfindungsgemäßen Näherungsschalter gilt nun, daß - schlicht und einfach - ein Sich-Nähern eines Betätigungsobjektes detektiert werden kann. Dafür sind aber eigentlich Näherungsschalter mit zwei Signalempfängern, wie im Stand der Technik, bzw. mit zwei Signalsendern, wie erfindungsgemäß vorgesehen, nicht erforderlich; das schlichte Sich-Nähern eines Betätigungsobjektes kann auch mit einem Signalsender und einem Signalempfänger detektiert werden. Näherungsschalter mit zwei Signalempfängern, wie im Stand der Technik, bzw. mit zwei Signalsendern, wie erfindungsgemäß vorgesehen, ermöglichen es vielmehr auch, zu detektieren, ob sich ein Betätigungsobjekt einer der beiden Empfangselektroden, wie im Stand der Technik vorgesehen, bzw. einer der beiden Sendeelektroden, wie erfindungsgemäß vorgesehen, mehr genähert hat als der anderen Empfangselektrode bzw. der anderen Sendeelektrode. Mit Näherungsschaltem der hier in Rede stehenden Art, also mit zwei Empfangselektroden, wie im Stand der Technik, bzw. mit zwei Sendeelektroden, wie erfindungsgemäß vorgesehen, kann auch detektiert werden, aus welcher Richtung das Sich-Nähern eines Betätigungsobjektes erfolgt.

Der wesentliche Unterschied zwischen den Näherungsschaltern, von denen die Erfindung ausgeht, und dem erfindungsgemäßen Näherungsschalter läßt sich auch wie folgt darstellen:

Bei den im Stand der Technik bekannten Näherungsschaltern, von denen die Erfmdung ausgeht, werden - durch ein Betätigungsobjekt - zwei elektrische Signale erzeugt, die als solche von den beiden Empfangselektroden über die zugeordneten Verarbeitungskanäle geführt werden. Hinter den Verarbeitungskanälen findet dann eine Differenzbildung der verarbeiteten elektrischen Signale statt. Demgegenüber findet bei dem erfindungsgemäßen Näherungsschalter eine Differenzbildung der beiden von den beiden Signalsendern kommenden und in den Signalübertragungswegen beeinflußten Signale vor dem einzigen Signalempfänger bzw. vor der einzigen Empfangselektrode statt. Der einzigen Empfangselektrode ist nur ein Verarbeitungskanal nachgeschaltet, so daß der weiter oben erläuterte systembedingte Nachteil, der bei zwei Verarbeitungskanälen auftreten kann, erfindungsgemäß systembedingt nicht auftreten kann.

Von besonderem Vorteil ist es, wenn bei dem erfindungsgemäßen Näherungsschalter die beiden Signalsender frequenzgespreizte Signale generieren. Das kann dadurch realisiert sein, daß die beiden Signalsender zum Generieren der frequenzgespreizten Signale jeweils eine Rauschsignalquelle aufweisen, oder, vorzugsweise, dadurch, daß den beiden Signalsendern zum Generieren der frequenzgespreizten Signale gemeinsam eine Rauschsignalquelle zugeordnet ist. Zu dem, was durch frequenzgespreizte Signale erreicht wird, wird auf den Offenbarungsgehalt der DE 198 13 013 A1 verwiesen.

Bei dem erfindungsgemäßen Näherungsschalter generieren die beiden Signalsender Ausgangssignale, die um 180° phasenverschoben sind. Das hat dann die Konsequenz, daß dann, wenn ein Betätigungsobjekt die beiden Signalübertragungswege identisch beeinflußt, der einzigen Empfangselektrode bzw. dem einzigen Signalempfänger ein Null-Signal zugeführt wird, so daß jede Abweichung von dem bei identischer Beeinflussung der Signalübertragungswege auftretenden Null-Signal besonders gut erkannt bzw. verarbeitet werden kann.

Zuvor ist darauf hingewiesen worden, daß dann, wenn der einzigen Empfangselektrode bzw. dem einzigen Signalempfänger ein Null-Signal zugeführt wird, jede Abweichung von dem Null-Signal besonders gut erkannt bzw. verarbeitet werden kann. Folglich ist ein besonders bevorzugtes Ausführungsbeispiel des erfindungsgemäßen Näherungsschalters, dem besondere Bedeutung zukommt, ergänzend dadurch gekennzeichnet, daß mindestens einer der beiden Signalsender - bzw. das Ausgangssignal mindestens einer der beiden Signalsender - gesteuert oder geregelt ist, und zwar vorzugsweise so, daß die Signaldifferenz am ersten Signaleingang des Signalempfängers null ist, also an der einzigen Empfangselektrode bzw. dem Signaleingang des einzigen Signalempfängers auch dann ein Null-Signal zugeführt wird, wenn ein Betätigungsobjekt die beiden Signalübertragungswege nicht identisch beeinflußt.

Im einzelnen gibt es nun eine Vielzahl von Möglichkeiten, den erfindungsgemäßen Näherungsschalter auszugestalten und weiterzubilden. Dazu wird verwiesen sowohl auf die dem Patentanspruch 1 nachgeordneten Patentansprüche als auch auf die Beschreibung der in der Zeichnung dargestellter Ausführungsbeispiele erfindungsgemäßer Näherungsschalter. In der Zeichnung zeigen
- Fig. 1: eine sehr schematische Darstellung zur Erläuterung des erfindungsgemäßen Näherungsschalters,
- Fig. 2: ein erstes Ausführungsbeispiel eines erfindungsgemäßen Näherungsschalters und
- Fig. 3: ein zweites Ausführungsbeispiel eines erfindungsgemäßen Näherungsschalters.

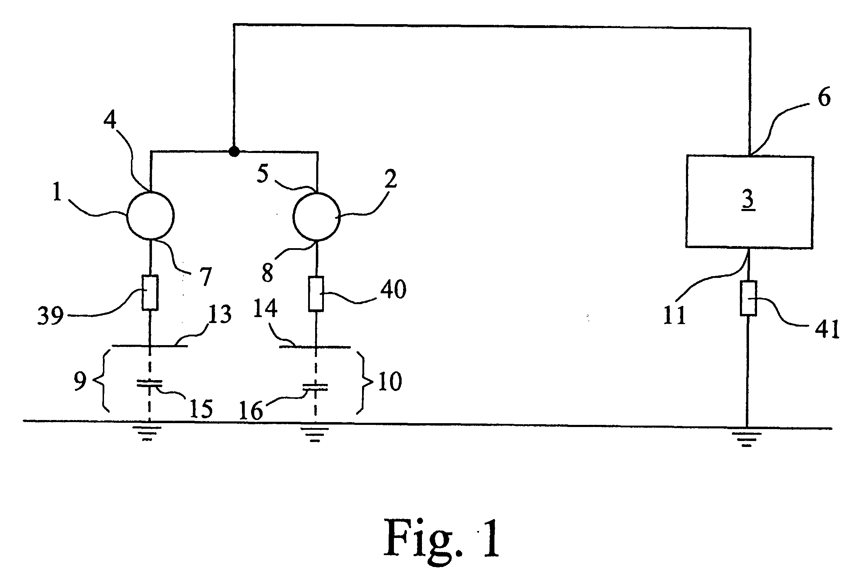

In den Figuren, in Fig. 1 sehr schematisch, ist das Schaltbild eines erfindungsgemäßen Näherungsschalters, und zwar eines kapazitiven Näherungsschalters, dargestellt. Zu diesem erfindungsgemäßen Näherungsschalter gehören zunächst zwei Signalsender 1, 2 und ein Signalempfänger 3. Die beiden Signalsender 1, 2 sind einerseits - jeweils mit ihrem ersten Signalausgang 4, 5 - miteinander und mit einem ersten Signaleingang 6 des Signalempfängers 3 verbunden, andererseits - jeweils mit ihrem zweiten Signalausgang 7, 8 - über jeweils einen Signalübertragungsweg 9, 10 mit dem zweiten Signaleingang 11 des Signalempfängers 3 verbunden bzw. verbindbar. Wenigstens einer der beiden Signalübertragungswege 9 oder 10 ist - durch ein nicht dargestelltes Betätigungsobjekt - beeinflußbar.

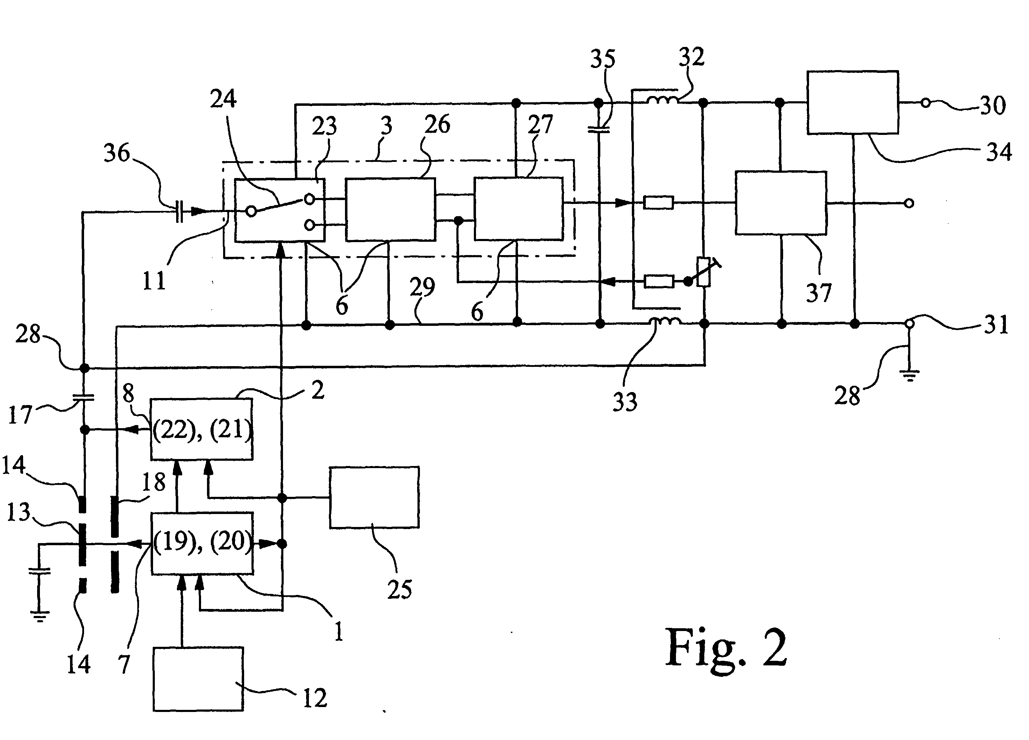

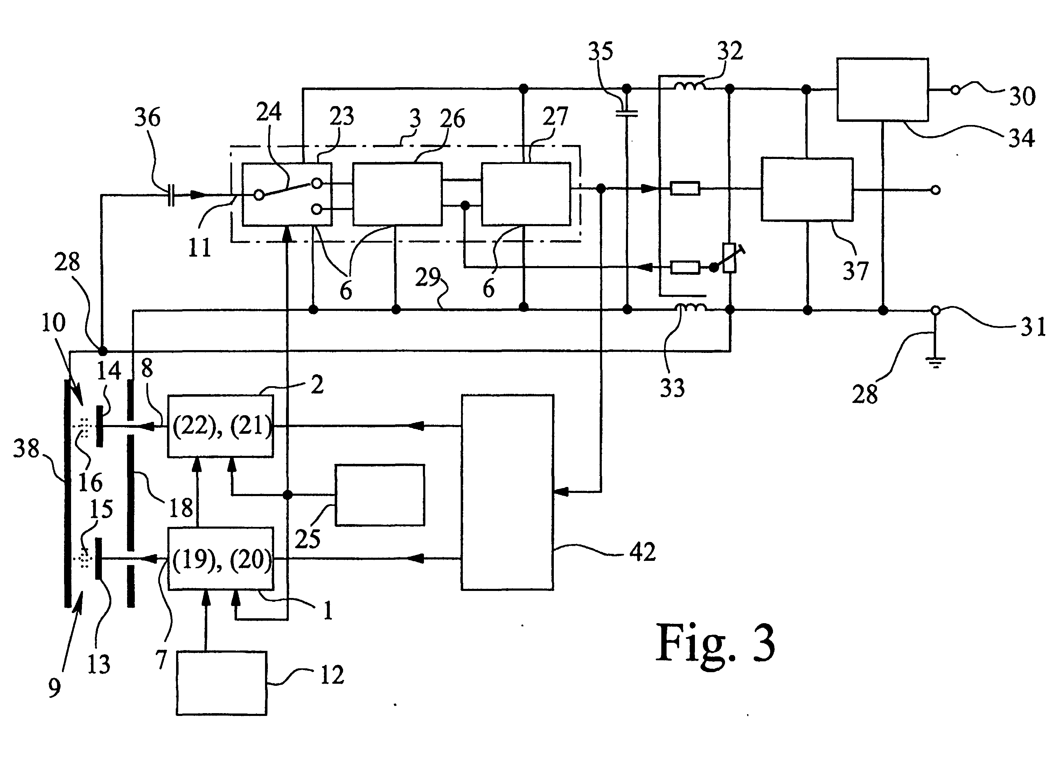

Für die Ausführungsbeispiele, die in den Fig. 2 und 3 dargestellt sind, gilt, daß die beiden Signalsender 1, 2 frequenzgespreizte Signale generieren. Dazu ist in den dargestellten Ausführungsbeispielen beiden Signalsendern 1, 2 eine Rauschsignalquelle 12 zugeordnet. Zu dem, was dadurch erreicht wird, daß die beiden Signalsender 1, 2 - in Verbindung mit der Rauschsignalquelle 12 - frequenzgespreizte Signale generieren, wird nochmals auf den Offenbarungsgehalt der DE 198 13 013 A 1 verwiesen.

Zu der Aussage, daß zu dem erfindungsgemäßen Näherungsschalter zwei Signalsender 1, 2 gehören, korrespondiert, daß zwei Sendeelektroden 13, 14 vorgesehen sind. Einerseits sind die Sendeelektroden 13, 14 an die zweiten Signalausgänge 7, 8 der Signalsender 1, 2 angeschlossen. Andererseits befinden sich zwischen den Sendeelektroden 13, 14 und dem Erdpotential die Signalübertragungswege 9, 10, die nur in den Fig. 1 und 3 dargestellt sind. Im übrigen ist nur in den Fig. 1 und 3 angedeutet, daß zu den Signalübertragungswegen 9, 10 Kapazitäten 15, 16 gehören, die sich beim Sich-Nähern eines Betätigungsobjektes ändern. Während bei den Ausfiihrungsbeispielen nach den Fig. 1 und 3 eine der beiden Kapazitäten 15 oder 16 die Ansprech- bzw. Meß-Kapazität und die andere der beiden Kapazitäten 16 oder 15 die Referenz-Kapazität sein kann, ist im Ausführungsbeispiel nach Fig. 2 eine besondere, als Kondensator ausgeführte Kapazität 17 als Referenz-Kapazität vorgesehen. Schließlich zeigen die Fig. 2 und 3 noch, daß bei den dargestellten Ausführungsbeispielen zusätzlich zu den Sendeelektroden 13 und 14 eine Masseelektrode 18 vorgesehen ist.

Weiter oben ist bereits darauf hingewiesen worden, daß bei dem erfindungsgemäßen Näherungsschalter die beiden Signalsender 1, 2 Ausgangssignale generieren, die um 180° phasenverschoben sind, weil das die Konsequenz hat, daß dann, wenn ein Betätigungsobjekt die beiden Signalübertragungswege 9, 10 identisch beeinflußt, dem einzigen Signalempfänger 3 ein Null-Signal zugeführt wird, so daß jede Abweichung von dem bei identischer Beeinflussung der Signalübertragungswege 9, 10 auftretenden Null-Signal besonders gut erkannt bzw. verarbeitet werden kann. Folglich ist für alle dargestellten Ausführungsbeispiele vorgesehen, daß die beiden Signalsender 1, 2 Ausgangssignale generieren, die um 180° phasenverschoben sind. Das ist dadurch realisiert, daß die beiden Signalsender 1, 2 aus einem beiden Signalsendern 1, 2 gemeinsamen Signalgenerator 19 und jeweils einem in Reihe zu dem Signalgenerator 19 liegenden Umschalter 20, 21 bestehen und daß einem der beiden Umschalter 20, 21, in den in den Fig. 2 und 3 dargestellten Ausführungsbeispielen dem Umschalter 21, ein Inverter 22 vor- oder nachgeschaltet ist.

Für die in den Fig. 2 und 3 dargestellten Ausführungsbeispiele erfindungsgemäßer kapazitiver Näherungsschalter gilt weiter, daß der Signalempfänger 3 einen dem zweiten Signaleingang 11 nachgeschalteten phasenempfindlichen Synchrongleichrichter 23 aufweist, der seinerseits eingangsseitig einen Umschalter 24 aufweist. Vorzugsweise sind die beiden zu den Signalsendern 1, 2 gehörenden Umschalter 20, 21, die in Reihe zu dem Signalgenerator 19 liegen, und der Umschalter 24 des Synchrongleichrichters 23 durch einen Multiplexer realisiert. (Zum Aufbau und zur Funktionsweise eines Multiplexers wird auf Tietze . Schenk "Halbleiter-Schaltungstechnik", 10. Auflage, Abschnitt 9.6.3, Seiten 226 bis 228, verwiesen.) Die beiden in Reihe zu dem Signalgenerator 19 liegenden Umschalter 20, 21 und der Umschalter 24 des Synchrongleichrichters 23 sind gleichzeitig schaltend angesteuert, in den in den Fig. 2 und 3 dargestellten Ausführungsbeispielen durch einen gemeinsamen Taktgenerator 25. Im übrigen gilt für die in den Fig. 2 und 3 dargestellten Ausführungsbeispiele erfindungsgemäßer kapazitiver Näherungsschalter, daß der Signalempfänger 3 einen Tiefpaß 26 und einen Analogverstärker 27 aufweist, der vorzugsweise als mit einer Hysterese versehener Komparator ausgeführt ist.

Für die in den Fig. 2 und 3 dargestellten Ausführungsbeispiele erfindungsgemäßer kapazitiver Näherungsschalter ist noch folgendes von Bedeutung:

Wie man den Fig. 2 und 3 entnehmen kann, liegt der Signalempfänger 3 - mit seinem ersten Signaleingang 6, der dreimal dargestellt ist, und mit seinem zweiten Signaleingang 11 - zwischen dem Massepotential und dem Erdpotential 28. Betrachtet man - richtigerweise - das Erdpotential 28 als - festes - Bezugspotential, so kann an den Signaleingängen 6 und 11 des Signalempfängers 3 ein Signal nur wirksam werden bzw. vorliegen, wenn ein "Floaten" des Massepotentials 29 möglich bzw. ermöglicht ist.

Wie die Fig. 2 und 3 zeigen, sind die dargestellten Ausführungsbeispiele erfindungsgemäßer kapazitiver Näherungsschalter mit zwei dem Anschluß des Näherungsschalters an eine Betriebsspannung dienenden Betriebsspannungsanschlüssen 30, 31 versehen, wobei der Betriebsspannungsanschluß 31 auf dem Erdpotential 28 liegt. Damit nun das Massepotential 29 gegenüber dem Erdpotential 28 "floaten" kann, ist das Massepotential 29, das gleichstrom- bzw. gleichspannungsmäßig mit dem Erdpotential 28 verbunden ist, hochfrequenzmäßig von dem Erdpotential 28 entkoppelt, und zwar dadurch, daß den Betriebsspannungsanschlüssen 30, 31 jeweils eine - vorzugsweise stromkompensierte - Drossel 32, 33 nachgeschaltet ist. Dabei liegt die Drossel 33 parallel zu den Signaleingängen 6, 11 des Signalempfängers 3, wodurch, wegen der geringen Impedanz für eine Wechselspannung mit 50 Hz, ein sogenanntes Netzbrummen unterdrückt wird.

Im übrigen sei noch darauf hingewiesen, daß in den in den Fig. 2 und 3 dargestellten Ausführungsbeispielen erfindungsgemäßer kapazitiver Näherungsschalter noch weitere Funktionselemente vorgesehen sind, und zwar ein Spannungsregler 34, eingangsseitig, zwischen dem Betriebsspannungsanschluß 30 und der Drossel 32, ein Abblockkondensator 35, angeschlossen an die den Betriebsspannungsanschlüssen 30, 31 fernen Enden der Drosseln 32, 33, ein Koppelkondensator 36 vor dem zweiten Signaleingang 11 des Signalempfängers 3 und eine dem Signalempfänger 3 nachgeordnete Endstufe 37, die mit einer Schutzschaltung versehen sein kann.

Ferner sei noch auf Unterschiede zwischen den in den Fig. 2 und 3 dargestellten Ausführungsbeispielen erfindungsgemäßer kapazitiver Näherungsschalter hingewiesen, die nur die Ausbildung im Bereich der Sendeelektroden 13, 14 betreffen. Im Ausführungsbeispiel nach Fig. 2 umgibt die zweite Sendeelektrode 14 konzentrisch die erste Sendeelektrode 13. Der so ausgeführte kapazitive Näherungsschalter ist seitlich unempfindlich, weil die zweite Sendeelektrode 14 gegen die erste Sendeelektrode 13 wirkt. Demgegenüber sind im Ausführungsbeispiel nach Fig. 3 die beiden Sendeelektroden 13, 14 nebeneinander angeordnet, und zwar gegenüber einer Gegenelektrode 38, die mit dem Erdpotential 28 verbunden ist. Dieses Ausführungsbeispiel ermöglicht z. B. ein Zählen von Etiketten, ein Erkennen von Klebestellen und ein Vergleichen von Materialdicken.

Hingewiesen sei auch auf eine Besonderheit, die für das Ausführungsbeispiel nach Fig. 1 gilt. Bei diesem Ausführungsbeispiel ist in beiden Signalübertragungswegen 9, 10 ein Signalverzögerungsglied, und zwar ein Widerstand 39, 40, vorgesehen; ein weiterer Widerstand 41 ist vor dem zweiten Signaleingang 11 des Signalempfängers 3 vorgesehen. Die Widerstände 39, 40, 41 führen dazu, daß die Signalströme etwas zeitverzögert fließen, so daß der Synchrongleichrichter 23 dann, wenn die Signalströme "ankommen", schon "empfangsbereit ist", - obwohl der zu dem Synchrongleichrichter 23 gehörende Umschalter 24 gleichzeitig mit den beiden Umschaltern 20, 21, die zu den Signalsendern 1, 2 gehören, schaltet.

Das Ausführungsbeispiel nach Fig. 3 unterscheidet sich von dem Ausführungsbeispiel nach Fig. 2 gravierend dadurch, daß beim Ausführungsbeispiel nach Fig. 3 beide Signalsender 1, 2 - bzw. die Ausgangssignale der beiden Signalsender 1, 2 - gesteuert oder geregelt sind, - und zwar so, daß am ersten Signaleingang 6 des Signalempfängers 3 die Signaldifferenz, herrührend von den Ausgangssignalen der beiden Signalsender 1, 2, also das Eingangssignal am Signalempfänger 3, null ist, dem Signalempfänger 3 also ein Null-Signal zugeführt wird.

Zur Steuerung bzw. Regelung der beiden Signalsender 1, 2 bzw. der Ausgangssignale der beiden Signalsender 1, 2 könnte das Ausgangssignal des phasenempfindlichen Synchrongleichrichters 3 verwendet sein. In dem in Fig. 3 dargestellten Ausfiihrungsbeispiel ist jedoch zur Steuerung bzw. Regelung der beiden Signalsender 1, 2 bzw. der Ausgangssignale des Signalsender 1, 2 das Ausgangssignal des Analogverstärkers 27 verwendet.

Mit der Vorgabe, die beiden Signalsender 1, 2 bzw. die Ausgangssignale der beiden Signalsender 1, 2 zu steuern oder zu regeln, und zwar so, daß am Signaleingang 6 des Signalempfängers 3 die aus den Ausgangssignalen des Signalsender 1, 2 resultierende Signaldifferenz null ist, kann der Fachmann ohne weiteres schaltungstechnische Details regeln, die hier nicht im einzelnen beschrieben werden müssen.

Das, was zuvor im wesentlichen funktional, gleichwohl für den Fachmann ohne weiteres nacharbeitbar, erläutert worden ist, ist im Ausführungsbeispiel nach Fig. 3 noch etwas konkreter dargestellt. Dieses Ausführungsbeispiel ist nämlich ergänzend dadurch gekennzeichnet, daß zur Steuerung bzw. Regelung der Ausgangssignale der Signalsender 1, 2 dem Ausgang des Analogverstärkers 27 ein gleichspannungsgesteuerter linearer Amplitudenmodulator bzw. HF-Generator, vorzugsweise in Form eines CMOS-Analogschalters 42, nachgeschaltet ist. Ein solcher CMOS-Analogschalter 42 hat den besonderen Vorteil der Linearität, d. h. das ihm zugeführte Gleichspannungssignal wird 1 : 1 in ein Wechselspannungssignal transformiert.

Weiter oben ist darauf hingewiesen worden, daß in den in den Fig. 1 und 2 dargestellten Ausführungsbeispielen beide Signalsender 1, 2 aus einem beiden Signalsender 1, 2 gemeinsamen Signalgenerator 19 und weiteren Bauteilen bestehen. Wird, wie zuvor ausgeführt, zur Steuerung bzw. Regelung der beiden Signalsender 1, 2 bzw. der Ausgangssignale der beiden Signalsender 1, 2 ein gleichspannungsgesteuerter linearer Amplitudenmodulator bzw. HF-Generator, insbesondere ein CMOS-Analogschalter 42, verwendet, dann kann auf den Signalgenerator 19 verzichtet werden, kann nämlich der gleichspannungsgesteuerte lineare Amplitudenmodulator bzw. der HF-Generator, insbesondere in Form eines CMOS-Analogschalters 42, als Signalgenerator für die Signalsender 1, 2 verwendet werden.

Zuvor ist in bezug auf das Ausführungsbeispiel nach Fig. 3 dargestellt worden, daß beide Signalsender 1, 2 bzw. die Ausgangssignale beider Signalsender 1, 2 gesteuert oder geregelt sind. Es besteht aber auch die Möglichkeit, nur den Signalsender 1 oder nur den Signalsender 2 zu steuern oder zu regeln. Betrachtet man den Signalsender 1 als Meßsender und den Signalsender 2 als Referenzsender, das Ausgangssignal des Signalsenders 1 also als Meßsignal und das Ausgangssignal des Signalsenders 2 als Referenzsignal, so läßt sich noch wertend folgendes ausführen:

Wird das Ausgangssignal des Signalsenders 1, also das Meßsignal, gesteuert oder geregelt, so erzielt man als Vorteil, daß bei einer Zunahme der Meßgröße keine Aussteuergrenze vorliegt, daß man eine Kennlinienentzerrung erreicht und daß sich der Übertragungsfaktor, also die Steilheit, verändert (Dynamikkompression). Wird das Ausgangssignal des Signalsenders 2, also das Referenzsignal, gesteuert oder geregelt, so ist das insoweit vorteilhaft, als man einen von der Referenz-Kapazität unabhängigen Übertragungsfaktor hat, die Empfindlichkeit also immer gleich ist. Nachteilig ist dabei jedoch, daß der Aussteuerbereich begrenzt ist. Sowohl das Ausgangssignal des Signalsenders 1, also das Meßsignal, als auch das Ausgangssignal des Signalsenders 2, also das Referenzsignal, zu steuern oder zu regeln, ist insbesondere dann sinnvoll, wenn beide Signalübertragungswege betriebsmäßig beeinflußt werden können, wie das weiter oben erläutert worden ist.

Schließlich sei noch darauf hingewiesen, daß das, was zuvor in bezug auf das Ausführungsbeispiel nach Fig. 3 erläutert worden ist, also das Steuern bzw. Regeln der Ausgangssignale der beiden Signalsender 1, 2 bzw. des Ausgangssignals des Signalsenders 1 oder des Ausgangssignals des Signalsenders 2, vor allem die Möglichkeit schafft, die Empfindlichkeit des so ausgestalteten Näherungsschalters relativ einfach auf elektronischem Wege einzustellen.

## Patentansprüche

1. Näherungsschalter, insbesondere kapazitiver Näherungsschalter, mit zwei Signalsendern (1, 2) und mit einem Signalempfänger (3), wobei die beiden Signalsender (1, 2) aus einem beiden Signalsendern (1, 2) gemeinsamen Signalgenerator (19) gespeist werden, an beiden Signalausgängen (4, 7 und 5, 8) jedes Signalsenders (1, 2) jeweils ein Ausgangssignal der gleichen Frequenz ansteht und die Ausgangssignale an den jeweils ersten Signalausgängen (4, 5) im unbetätigten Zustand die gleiche Amplitude bei einer Phasenverschiebung von 180° haben und wobei die beiden Signalsender (1, 2) einerseits - jeweils mit ihrem ersten Signalausgang (4, 5) - miteinander und mit einem ersten Signaleingang (6) des Signalempfängers (3) verbunden sind und andererseits - jeweils mit ihrem zweiten Signalausgang (7, 8) - über jeweils einen Signalübertragungsweg (9, 10) mit dem zweiten Signaleingang (11) des Signalempfängers (3) verbunden oder verbindbar sind und wobei wenigstens einer der beiden Signalübertragungswege (9, 10) beeinflußbar ist.

2. Näherungsschalter nach Anspruch 1, **dadurch gekennzeichnet, daß** die beiden Signalsender (1, 2) frequenzgespreizte Signale generieren.

3. Näherungsschalter nach Anspruch 2, **dadurch gekennzeichnet, daß** die beiden Signalsender zum Generieren der frequenzgespreizten Signale jeweils eine Rauschsignalquelle aufweisen.

4. Näherungsschalter nach Anspruch 2, **dadurch gekennzeichnet, daß** den beiden Signalsendem (1, 2) zum Generieren der frequenzgespreizten Signale gemeinsam eine Rauschsignalquelle (12) zugeordnet ist.

5. Näherungsschalter nach einem der Ansprüche 1 bis 4, **dadurch gekennzeichnet, daß** der Signalempfänger (3) einen dem zweiten Signaleingang (11) nachgeschalteten phasenempfindlichen Synchrongleichrichter (23) aufweist.

6. Näherungsschalter nach Anspruch 5, **dadurch gekennzeichnet, daß** der Synchrongleichrichter (23) eingangsseitig einen Umschalter (24) aufweist.

7. Näherungsschalter nach Anspruch 6, **dadurch gekennzeichnet, daß** die beiden in Reihe zu dem Signalgenerator (19) liegenden Umschalter (20, 21) und der Umschalter (24) des Synchrongleichrichters (23) durch einen Multiplexer realisiert sind.

8. Näherungsschalter nach Anspruch 6 oder 7, **dadurch gekennzeichnet, daß** die beiden in Reihe zu dem Signalgenerator (19) liegenden Umschalter (20, 21) und der Umschalter (24) des Synchrongleichrichters (23) gleichzeitig schaltend angesteuert sind, vorzugsweise durch einen gemeinsamen Taktgenerator (25).

9. Näherungsschalter nach einem der Ansprüche 1 bis 8, **dadurch gekennzeichnet, daß** der Signalempfänger (3) einen Tiefpaß (26) aufweist.

10. Näherungsschalter nach einem der Ansprüche 1 bis 9, **dadurch gekennzeichnet, daß** der Signalempfänger (3) einen Analogverstärker (27) oder einen - vorzugsweise mit einer Hysterese versehenen - Komparator aufweist.

11. Näherungsschalter nach einem der Ansprüche 1 bis 10, insbesondere nach Anspruch 8, **dadurch gekennzeichnet, daß** in wenigstens einem der beiden Signalübertragungswege (9, 10), vorzugsweise in beiden Signalübertragungswegen (9, 10), oder/und vor dem zweiten Signaleingang (11) des Signalempfängers (3) ein bzw. jeweils ein Signalverzögerungsglied, vorzugsweise ein Widerstand (39, 40, 41), vorgesehen ist.

12. Näherungsschalter nach einem der Ansprüche 1 bis 11, mit zwei dem Anschluß des Näherungsschalters an eine Betriebsspannung dienenden Betriebsspannungsanschlüssen (30, 31), **dadurch gekennzeichnet, daß** den Betriebsspannungsanschlüssen (30, 31) jeweils eine - vorzugsweise stromkompensierte - Drossel (32, 33) nachgeschaltet ist.

13. Näherungsschalter nach Anspruch 12, **dadurch gekennzeichnet, daß** eine Drossel (33) oder/und ein RC-Glied an die beiden Signaleingänge (6, 11) des Signalempfängers (3) angeschlossen ist.

14. Näherungsschalter nach einem der Ansprüche 1 bis 13, **dadurch gekennzeichnet, daß** mindestens einer der beiden Signalsender (1, 2) - bzw. das Ausgangssignal mindestens einer der beiden Signalsender (1, 2) - gesteuert oder geregelt ist.

15. Näherungsschalter nach Anspruch 14, **dadurch gekennzeichnet, daß** mindestens das Ausgangssignal eines Signalsenders (1, 2) so gesteuert oder geregelt ist, daß am ersten Signaleingang (6) des Signalempfängers (3) die Signaldifferenz null ist.

16. Näherungsschalter nach einem der Ansprüche 5 bis 13 und nach Anspruch 14 oder 15, **dadurch gekennzeichnet, daß** zur Steuerung bzw. Regelung mindestens einer der beiden Signalsender (1, 2) bzw. des Ausgangssignals mindestens einer der beiden Signalsender (1, 2) das Ausgangssignal des phasenempfindlichen Synchrongleichrichters (23) verwendet ist.

17. Näherungsschalter nach einem der Ansprüche 10 bis 13 und nach Anspruch 14 oder 15, **dadurch gekennzeichnet, daß** zur Steuerung bzw. Regelung mindestens einer der beiden Signalsender (1, 2) bzw. des Ausgangssignals mindestens einer der beiden Signalsender (1, 2) das Ausgangssignal des Analogverstärkers (27) verwendet ist.

18. Näherungsschalter nach einem der Ansprüche 14 bis 17, **dadurch gekennzeichnet, daß** zur Steuerung bzw. Regelung mindestens einer der beiden Signalsender (1, 2) bzw. des Ausgangssignals mindestens einer der beiden Signalsender (1, 2) dem Ausgang des phasenempfindlichen Synchrongleichrichters (23) oder dem Ausgang des Analogverstärkers (27) ein gleichspannungsgesteuerter linearer Amplitudenmodulator bzw. HF-Generator, vorzugsweise in Form eines COMS-Analogschalters (42), nachgeschaltet ist.

19. Näherungsschalter nach Anspruch 18, **dadurch gekennzeichnet, daß** der gleichspannungsgesteuerte lineare Amplitudenmodulator bzw. HF-Generator, insbesondere in Form eines COMS-Analogschalters (42), als Signalgenerator des ersten Signalsenders (1) oder/und des zweiten Signalsenders (2) verwendet ist.

## Claims

1. Proximity switch, in particular a capacitive proximity switch, having two signal transmitters (1, 2) and having a signal receiver (3), with the two signal transmitters (1, 2) being fed from a signal generator (19) which is shared by the two signal transmitters (1, 2), with an output signal at the same frequency being produced at each of the two signal outputs (4, 7 and 5, 8) of each signal transmitter (1, 2), and with the output signals at the respective first signal outputs (4, 5) being at the same amplitude but with a phase shift of 180º in the unoperated state, and with the two signal transmitters (1, 2) on the one hand being connected to each other - in each case by their first signal output (4, 5) - and to a first signal input (6) of the signal receiver (3), and on the other hand being connected, or connectable - in each case by their second signal output (7, 8) - via a respective signal transmission path (9, 10) to the second signal input (11) of the signal receiver (3), and in which case at least one of the two signal transmission paths (9, 10) can be influenced.

2. Proximity switch according to Claim 1, **characterized in that** the two signal transmitters (1, 2) generate spread-frequency signals.

3. Proximity switch according to Claim 2, **characterized in that** the two signal transmitters each have a noise signal source for generation of the spread-frequency signals.

4. Proximity switch according to Claim 2, **characterized in that** the two signal transmitters (1, 2) are jointly associated with one noise signal source (12) for generation of the spread-frequency signals.

5. Proximity switch according to one of Claims 1 to 4, **characterized in that** the signal receiver (3) has a phase-sensitive synchronous detector (23), which is connected downstream from the second signal input (11).

6. Proximity switch according to Claim 5, **characterized in that** the synchronous detector (23) has a changeover switch (24) on the input side.

7. Proximity switch according to Claim 6, **characterized in that** the two changeover switches (20, 21) which are connected in series with the signal generator (19), and the changeover switch (24) for the synchronous detector (23), are formed by a multiplexer.

8. Proximity switch according to Claim 6 or 7, **characterized in that** the two changeover switches (20, 21) which are connected in series with the signal generator (19), and the changeover switch (24) for the synchronous detector (23), are driven such that they switch simultaneously, preferably by means of a common clock generator (25).

9. Proximity switch according to one of Claims 1 to 8, **characterized in that** the signal receiver (3) has a low-pass filter (26).

10. Proximity switch according to one of Claims 1 to 9, **characterized in that** the signal receiver (3) has an analogue amplifier (27) or a comparator, which is preferably provided with hysteresis.

11. Proximity switch according to one of Claims 1 to 10, in particular according to Claim 8, **characterized in that** one or in each case one signal delay element, preferably a resistance (39, 40, 41), is provided in at least one of the two signal transmission paths (9, 10), preferably in both signal transmission paths (9, 10), and/or upstream of the second signal input (11) of the signal receiver (3).

12. Proximity switch according to one of Claims 1 to 11, having two operating voltage connections (30, 31) which are used for connection of the proximity switch to an operating voltage, **characterized in that** the operating voltage connections (30, 31) are followed by a respective - preferably current-compensated - inductor (32, 33).

13. Proximity switch according to Claim 12, **characterized in that** an inductor (33) and/or an RC element are/is connected to the two signal inputs (6, 11) of the signal receiver (3).

14. Proximity switch according to one of Claims 1 to 13, **characterized in that** at least one of the two signal transmitters (1, 2) - or the output signal from at least one of the two signal transmitters (1, 2) - is subject to open-loop or closed-loop control.

15. Proximity switch according to Claim 14, **characterized in that** at least the output signal from one signal transmitter (1, 2) is subject to open-loop or closed-loop control such that the signal difference at the first signal input (6) of the signal receiver (3) is zero.

16. Proximity switch according to one of Claims 5 to 13 and according to Claim 14 or 15, **characterized in that** the output signal from the phase-sensitive synchronous detector (23) is used for open-loop or closed-loop control of at least one of the two signal transmitters (1, 2), or of the output signal from at least one of the two signal transmitters (1, 2).

17. Proximity switch according to one of Claims 10 to 13 and according to Claim 14 or 15, **characterized in that** the output signal from the analogue amplifier (27) is used for open-loop or closed-loop control of at least one of the two signal transmitters (1, 2) or of the output signal from at least one of the two signal transmitters (1, 2).

18. Proximity switch according to one of Claims 14 to 17, **characterized in that** the output from the phase-sensitive synchronous detector (23) or the output from the analogue amplifier (27) is followed by a linear amplitude modulator or RF generator, which is subject to DC voltage control, preferably in the form of a COMS analogue switch (42), for open-loop or closed-loop control of at least one of the two signal transmitters (1, 2) or of the output signal from at least one of the two signal transmitters (1, 2).

19. Proximity switch according to Claim 18, **characterized in that** the linear amplitude modulator or RF generator which is subject to DC voltage control and, in particular, is in the form of a COMS analogue switch (42) is used as a signal generator for the first signal transmitter (1) and/or for the second signal transmitter (2).

## Revendications

1. Contacteur de proximité, en particulier contacteur de proximité capacitif, doté de deux émetteurs de signaux (1, 2) et d'un récepteur de signaux (3), les deux émetteurs de signaux (1, 2) étant alimentés par un générateur de signaux (19) commun aux deux émetteurs de signaux, un signal de sortie de même fréquence étant appliqué sur les deux sorties de signaux (4, 7 et 5, 8) de chaque émetteur de signaux (1, 2) et les signaux de sortie appliqués sur les premières sorties de signaux (4, 5) respectives à l'état non activé ayant la même amplitude et un déphasage de 180°, les deux émetteurs de signaux (1, 2) étant reliés d'une part l'un à l'autre et à une première entrée de signaux (6) du récepteur de signaux (3), chacun par leur première sortie de signaux (4, 5), et étant reliés ou pouvant être reliés d'autre part, chacun par sa deuxième sortie de signaux (7, 8) à la deuxième entrée de signaux (11) du récepteur de signaux (3), chacun par l'intermédiaire d'un parcours (9, 10) de transmission de signaux, au moins l'un des deux parcours (9, 10) de transfert de signaux pouvant être influencé.

2. Contacteur de proximité selon la revendication 1, **caractérisé en ce que** les deux émetteurs de signaux (1, 2) créent des signaux à étalement de fréquence.

3. Contacteur de proximité selon la revendication 2, **caractérisé en ce que** pour créer les signaux à étalement de fréquence les deux émetteurs de signaux présentent tous deux une source de signaux de bruit.

4. Contacteur de proximité selon la revendication 2, **caractérisé en ce qu'**une source (12) de signaux de bruit commune est associée aux deux émetteurs de signaux (1, 2) pour la création des signaux à étalement de fréquence.

5. Contacteur de proximité selon l'une des revendications 1 à 4, **caractérisé en ce que** le récepteur de signaux (3) présente un redresseur synchrone (23) sensible à la phase et raccordé en aval de la deuxième entrée de signaux (11).

6. Contacteur de proximité selon la revendication 5, **caractérisé en ce que** le redresseur synchrone (23) présente à sa sortie un convertisseur (24).

7. Contacteur de proximité selon la revendication 6, **caractérisé en ce que** les deux convertisseurs (20, 21) raccordés en série sur le générateur de signaux (19) et le convertisseur (24) du redresseur synchrone (23) sont réalisés par un multiplexeur.

8. Contacteur de proximité selon les revendications 6 ou 7, **caractérisé en ce que** les deux convertisseurs (20, 21) raccordés en série sur le générateur de signaux (19) et le convertisseur (24) du redresseur synchrone (23) sont activés pour contacter simultanément, de préférence par un générateur d'horloge (25) commun.

9. Contacteur de proximité selon l'une des revendications 1 à 8, **caractérisé en ce que** le récepteur de signaux (3) présente un filtre passe-bas (26).

10. Contacteur de proximité selon l'une des revendications 1 à 9, **caractérisé en ce que** le récepteur de signaux (3) présente un amplificateur analogique (27) ou un comparateur de préférence doté d'une hystérèse.

11. Contacteur de proximité selon l'une des revendications 1 à 10, et en particulier selon la revendication 8, **caractérisé en ce que** dans au moins l'un des parcours (9, 10) de transmission de signaux, de préférence dans les deux parcours (9, 10) de transmission des signaux, et/ou en amont de la deuxième entrée des signaux (11) du récepteur de signaux (3) est prévu un organe de retardement des signaux ou chaque fois un tel organe, de préférence une résistance (39, 40, 41).

12. Contacteur de proximité selon l'une des revendications 1 à 11, qui présente deux raccordements (30, 31) à la tension d'alimentation qui servent à raccorder le contacteur de proximité à une tension d'alimentation, **caractérisé en ce qu'**une inductance (32, 33), de préférence compensée en courant, est raccordée en aval de chaque raccordement (30, 31) à la tension d'alimentation.

13. Contacteur de proximité selon la revendication 12, **caractérisé en ce qu'**une inductance (33) et/ou un élément RC sont raccordés aux deux entrées de signaux (6, 11) du récepteur de signaux (3).

14. Contacteur de proximité selon l'une des revendications 1 à 13, **caractérisé en ce qu'**au moins l'un des deux émetteurs de signaux (1, 2) ou le signal de sortie d'au moins l'un des deux émetteurs de signaux (1, 2) sont commandés ou régulés.

15. Contacteur de proximité selon la revendication 14, **caractérisé en ce qu'**au moins le signal de sortie d'un émetteur de signaux (1, 2) est commandé ou régulé de telle sorte que la différence entre les signaux sur la première entrée de signaux (6) du récepteur de signaux (3) soit nulle.

16. Contacteur de proximité selon l'une des revendications 5 à 13 et selon les revendications 14 ou 15, **caractérisé en ce que** pour la commande ou la régulation d'au moins l'un des deux émetteurs de signaux (1, 2) ou du signal de sortie d'au moins l'un des deux émetteurs de signaux (1, 2), on utilise le signal de sortie du redresseur synchrone (23) sensible à la phase.

17. Contacteur de proximité selon l'une des revendications 10 à 13 et selon les revendications 14 ou 15, **caractérisé en ce que** pour la commande ou la régulation d'au moins l'un des deux émetteurs de signaux (1, 2) ou du signal de sortie d'au moins l'un des deux émetteurs de signaux (1, 2), on utilise le signal de sortie de l'amplificateur analogique (27).

18. Contacteur de proximité selon l'une des revendications 14 à 17, **caractérisé en ce que** pour commander ou réguler au moins l'un des deux émetteurs de signaux (1, 2) ou le signal de sortie d'au moins l'un des deux émetteurs de signaux (1, 2), un modulateur linéaire commandé par tension continue ou un générateur HF qui présente de préférence la forme d'un contacteur analogique COMS (42) sont raccordés en aval de la sortie du redresseur synchrone (23) sensible à la phase ou à la sortie de l'amplificateur analogique (27).

19. Contacteur de proximité selon la revendication 18, **caractérisé en ce que** le modulateur linéaire d'amplitude commandé par tension continue ou le générateur HF qui présente en particulier la forme d'un commutateur analogique COMS (42) sont utilisés comme générateur de signaux pour le premier émetteur de signaux (1) et/ou le deuxième émetteur de signaux (2).
